# EUROPÄISCHE PATENTSCHRIFT

(11) **EP 2 668 514 B1**
(45) Veröffentlichungstag und Bekanntmachung des Hinweises auf die Patenterteilung: **15.08.2018**
(21) Anmeldenummer: 12703960.0
(22) Anmeldetag: 26.01.2012
(51) Int. Cl.: G01R 31/08, G01R 31/11, G01R 31/10

(54) **VERFAHREN UND VORRICHTUNG ZUR FEHLERORTUNG**
METHOD AND DEVICE FOR LOCATING A FAULT
PROCÉDÉ ET DISPOSITIF DE LOCALISATION DE DÉFAUT

(30) Priorität: 26.01.2011 DE 102011009512
(43) Veröffentlichungstag der Anmeldung: 04.12.2013
(73) Patentinhaber: MS-Technik Mess- und Regelungstechnik GmbH & Co. KG, 24232 Schönkirchen (DE)
(72) Erfinder: SCHACHT, Sebastian, 20144 Hamburg (DE)
(74) Vertreter: Hausfeld, Norbert
(86) Internationale Anmeldenummer: PCT/EP2012/000344
(87) Internationale Veröffentlichungsnummer: WO 2012/100945

(56) Entgegenhaltungen:
- DE-A1- 3 711 593
- DE-B1- 2 610 484
- FR-A1- 2 485 745
- GB-A- 1 162 811
- JP-A- 58 019 570
- JP-A- 58 129 272
- US-A- 3 727 128
- US-A- 4 291 204
- "Vorortung mit Lichtbogenreflexionsverfahren", , 20. Januar 2011 (2011-01-20), Seiten 1-12, XP55028556, Gefunden im Internet: URL:www.sebakmt.com/fileadmin/files/applik ationsschriften/fehlerortung/5-Vorortung-L ichtbogenreflexionsverfahren-de.pdf [gefunden am 2012-05-31] in der Anmeldung erwähnt

## Beschreibung

Die Erfindung betrifft ein Verfahren und eine Vorrichtung zur Fehlerortung gemäß den Oberbegriffen der Ansprüche 1 und 6.

Elektrische Leitungen können Fehler aufweisen, die zuerst gefunden werden müssen, bevor man sie reparieren kann. Meist liegt an der Defektstelle ein Isolationsfehler vor, bei dem die Isolation des spannungsführenden Leiters zur Erde oder zu einem benachbarten Leiter, z.B. einem Nullleiter, unzureichend ist. Es kommt zu Durchschlägen und dadurch bedingten schweren Netzstörungen. Meist treten diese Isolationsfehler intermittierend auf, weil sie bei Nennspannung noch nicht auftreten, sondern erst bei Überspannungen, die z.B. durch Schaltstörungen erzeugt werden

Schwierig ist die Ortung der Defektstelle. Zumeist wird dabei zweistufig mit Vorortung und Nachortung gearbeitet. Vorortung geschieht zumeist mit der Impulsreflexionsmethode, die eine Impulsreflexion am Fehlerort nutzt und aus Laufzeitbestimmungen die Entfernung berechnet. Das Ergebnis ist allerdings ungenau, da diese Methode Entfernungsungenauigkeiten von ca. 5 - 10 m aufweist. Daher ist meist eine Nachortung erforderlich. Bei Fehlern zwischen Leitern wird dazu üblicherweise mit der Methode der akustischen Nachortung gearbeitet. Beide Ortungsmethoden sind in dem Aufsatz
"Methoden der Fehlerortung in Niederspannungsnetzen",
Dr. Borneburg, Walter, Cichowsky und Dr. Merschel,
"Jahrbuch Anlagentechnik für elektrische Verteilungsnetze 2008",
   VDE Verlag GmbH, Dezember 2007,Seiten 338 ff.,
   Kapitel 2.2.2
beschrieben.

Die Impulsreflexionsmethode benötigt an der Defektstelle einen Kurzschluss, um eine gute Reflexion zu gewährleisten. Ein Kurzschluss wird an einer nichtleitenden Defektstelle einfach und wirkungsvoll von einem Lichtbogen erzeugt, der über einen unzureichenden Isolationsabstand hinweg brennt. Hierbei kommt es auf Stabilität und Störungsfreiheit des Lichtbogens an.

Auch die Methode der akustischen Nachortung benötigt an der Defektstelle einen Lichtbogen, der in diesem Fall ein im Abstand hörbares Geräusch erzeugen muss.

Zur Erzeugung des Lichtbogens wird der die Defektstelle aufweisende Leiter (im Folgenden "Defektleiter" genannt) mit einem elektrischen Impuls derart hoher Spannung beaufschlagt, dass an der Defektstelle ein ionisiertes Plasma entsteht.

Bei einer hochohmigen Defektstelle wird ein Durchbruch durch Isoliermaterial oder über einen Luftspalt mit Hochspannung erreicht und schafft einen leitenden Plasmapfad. Wenn der Strom abbricht, erlischt das Plasma. Normalerweise ist dann die Defektstelle wieder hochohmig, bis der nächste Hochspannungsimpuls kommt.

Diesen Zwecken der Durchbrucherzeugung dienende Geräte sind in dem Prospekt
"Anwendung der Stoßwellengeneratoren SWG"
der Firma sebaKMT,
heruntergeladen von www.sebakmt.com, am 20. Januar 2011,
auf der dritten Seite, unter der Überschrift "Nachortung" beschrieben. In der Tabelle sind einige von dieser Firma angebotene Impulsgeneratoren angegeben. Man beachte die erheblichen Gewichte. Diese ergeben sich daraus, dass die Generatoren dazu ausgelegt sind, sowohl die hohen Durchschlagspannungen bis hin zu 30kV als auch die hohen Energien bis zu 3500 Joule erzeugen zu können. Die Generatoren arbeiten mit einem Ladekondensator. In der Tabelle sind die entsprechenden Kapazitäten angegeben.

Solche Geräte müssen zum Suchort transportiert werden, was mit erheblichen Problemen verbunden ist, die insbesondere durch das Gewicht hervorgerufen werden. Kleinere dieser Geräte können noch von zwei Personen getragen werden. Die größeren lassen sich nur auf einem Lastwagen transportieren. Entsprechend aufwendig und umständlich ist das Arbeiten mit solchen Geräten. Auch die Kosten sind daher sehr hoch.

Die US 3,727,128 A beschreibt ein Verfahren und eine Vorrichtung zur Vorortung von Fehlern durch Impulsreflexion in einem Mittelspannungsnetz. Es wird die an einem Mittelspannungsnetz vorliegende Nennspannung von über 5 kV verwendet, die an Isolationsdefektstellen aufgrund ihrer Spannungshöhe für die Zündung eines Plasmas allein ausreicht. Allerdings wird hier nur mit der Nennspannung des Netzes gearbeitet, so dass erst bei höherer als der Nennspannung zündende Defektstellen nicht gefunden werden.

In einem Niederspannungsnetz reicht die Nennspannung von üblicherweise 230V zur Zündung eines Plasmas (Lichtbogen) in der Regel nicht aus.

Es wird in diesem Text der in der allgemeinen Energieversorgung übliche Begriff Niederspannung für Spannungen unter 1000 V Wechselspannung bzw. 1500 V Gleichspannung verwendet, wozu die für die Versorgung von Privathaushalten üblicherweise verwendeten 230 V Wechselspannung gehören. Für alle oberhalb der Niederspannung liegenden Spannungsbereiche, einschließlich der Mittelspannung, wird hier der Begriff Hochspannung verwendet.

Ein weiteres Problem bei der Fehlersuche stellen die an ein Versorgungsnetz angeschlossenen Verbraucher dar. Diese sind sehr empfindlich gegen Überspannungen, so dass sie vor einer Fehlersuche unter Einsatz von Hochspannungsimpulsen in mühsamer Arbeit vom Netz genommen werden müssen. Für an öffentliche Niederspannungsnetze anschließbare Verbraucher gelten Vorschriften hinsichtlich der Verträglichkeit von Überspannungsimpulsen.

Ein gattungsgemäßes Verfahren wird in dem Prospekt
"Vorortung mit Lichtbogenreflexionsverfahren"
der Firma sebaKMT,
heruntergeladen von www.sebakmt.com, am 20. Januar 2011,
auf Seite 7 unter der Bezeichnung "Doppelstoßverfahren" beschrieben, bei dem ein Hochspannungsimpuls höherer Spannung den Durchbruch erzeugt, also den Lichtbogen mit ausreichend hoher Spannung zündet, und ein Hochspannungsimpuls niedrigerer Spannung anschließend die Lebensdauer des Lichtbogens verlängert. Hier werden aber wiederum sehr hohe Impulsspannungen verwendet, die sogar beim Hochspannungsimpuls niedrigerer Spannung noch auf Höhe der Mittelspannung, also über 5kV liegen. Für Niederspannungsnetze ist dieses Verfahren daher nicht verwendbar.

Die DE 2610484 B1 beschreibt ein Verfahren und eine Vorrichtung zur Erzeugung einer dauerhaften niederohmigen Kohlebrücke an einer Defektstelle eines mit einer Netzspannung versorgten Defektleiters, durch Verbrennen einer Isolierung zwischen dem Defektleiter und einem Rückleiter. Mittels eines auf die Netzspannung aufgesetzten Hochspannungsimpulses wird an der Defektstelle ein Lichtbogen gezündet und mit Unterstützung der Energie aus dem Niederspannungsnetz wird der Kabelfehler "niedergebrannt". Zum Schutz der Schaltungselektronik und zur Sperrung des Hochspannungsimpulses gegen eine Rückkopplung in das Niederspannungsnetz sind zwischen der Schaltelektronik und einem den Hochspannungsimpuls erzeugenden Hochspannungsgenerator eine in Reihe geschaltete Drossel und ein gegen Masse geschalteter Kondensator vorgesehen.

Die Aufgabe der vorliegenden Erfindung besteht darin, eine verbesserte Vorrichtung und ein verbessertes Verfahren zur Ortung einer Defektstelle in einer Versorgungsleitung zur Verfügung zu stellen, die bei geringen Handhabungsproblemen und Kosten für Niederspannungsnetze während der Fehlerortung eine Weiterversorgung von an die Versorgungsleitung angeschlossenen Verbrauchern erlaubt.

Diese Aufgabe wird gelöst durch ein Verfahren mit den Merkmalen des Anspruchs 1 und eine Vorrichtung mit den Merkmalen des Anspruchs 6.

Die Erfindung geht von der Erkenntnis aus, dass zum Zünden des Durchbruches ein elektrischer Impuls erforderlich ist, der eine hohe Spannung und auch eine gewisse sehr kleine Mindestdauer, aber nur eine sehr geringe Energie aufweisen muss. Die hohen Energien, die bekannte Geräte zur Verfügung stellen, sind nur zur Erzeugung des Schallimpulses bzw. zur Aufrechterhaltung eines stabilen Lichtbogens für die Reflexionsmethode erforderlich, aber nicht für die Zündung des Durchbruches. Die Erfindung verwendet daher einen Generator geringer Leistung zur Erzeugung eines Hochspannungsimpulses niedriger Energie, der zum Zünden eines Lichtbogens ausreicht.

Ein solcher Generator kann sehr leicht sein und ohne weiteres in einer Hand getragen werden. Die Impulsenergie kann problemlos unterhalb der Verträglichkeitsgrenze anzuschließender Verbraucher gehalten werden. Bei Ortungen an Niederspannungsnetzen kann daher das mühsame Entfernen aller angeschlossenen Verbraucher entfallen. Zusätzlich zu diesem Hochspannungsimpuls niedriger Energie wird der Defektleiter mit Niederspannung beaufschlagt, die mit hoher Leistung Strom nachliefern kann, wenn der Durchbruch des Lichtbogens erst einmal durch den Hochspannungsimpuls geschaffen wurde. Die niedrige Netzspannung reicht dann ohne weiteres aus, den Strom mit hoher Leistung aufrechtzuerhalten. Es ergibt sich also insgesamt eine sehr einfache, kleine und leichte Vorrichtung, die lediglich aus einem kleinen Hochspannungsimpulsgenerator und einem Netzanschluss besteht, und die folglich auch sehr kostengünstig ist. Die gesamte Vorrichtung kann eine Person in einem kleinen Koffer mit sich führen, wenn er zu einer Fehlersuche gerufen wird.

Das erfindungsgemäße Verfahren kann für die Reflexionsmethode verwendet werden, wobei der Niederspannungsimpuls im wesentlichen zum Verlängern der Lebensdauer des Lichtbogens über die Laufzeit des zu reflektierenden Impulses dient. Vorteilhaft gemäß Anspruch 2 wird das Verfahren jedoch für die akustische Ortung verwendet. Dabei muss sichergestellt werden, dass der elektrische Impuls eine ausreichend hohe Energie hat, damit das vom Plasma erzeugte Geräusch noch im Abstand hörbar ist, z.B. auf der Erdoberfläche über dem Defektleiter eines in der Erde verlegten Kabels. Zur Detektion werden üblicherweise Mikrofone verwendet. Ist die Impulsenergie hoch genug, so sind sogar die Erschütterungen des Bodens merkbar und mit den Füßen ortbar.

Die an den Defektleiter angelegte Phasenspannung des Netzes ist mit dem Hochspannungsimpuls überlagert, der prinzipiell an beliebiger Stelle auf der Wechselspannung des Netzes liegen kann. Vorteilhaft ist jedoch, wenn der Impuls auf das Maximum einer Halbwelle gelegt ist, damit die sich durch die Addition ergebende Maximalspannung höher liegt.

Im Normalfall eines sporadisch auftretenden Fehlers, der zum Testzeitpunkt hochohmig ist, muss der Hochspannungsimpuls einen Durchschlag mit einem entstehenden Lichtbogen schaffen, über dessen niederohmige Strecke anschließend der Wechselstrom des Netzes mit hoher Leistung fließt. Hierbei kommt es aber sehr schnell zu ungewollten Zerstörungen. Vorteilhaft ist daher, wenn der Strom nach dem Hochspannungsimpuls unterbrochen wird. Die Unterbrechung erfolgt zeitverzögert nach dem Hochspannungsimpuls, um dem Netzstrom Gelegenheit zu ausreichender Schallerzeugung zu geben bzw. den Ortungsimpuls zu reflektieren. Je nach erforderlicher Schallleistung kann es ausreichen, nur die angefangene Halbwelle der Netzspannung zu beenden. Für höhere Leistung können noch ein oder zwei Vollwellen hinzugefügt werden. Die Leistung sollte aber nicht zu hoch sein, damit die vorgeschaltete Sicherung nicht anspricht. Die Unterbrechung kann kurzzeitig sein. Die Netzspannung kann dann wieder für den regulären Netzbetrieb angeschaltet werden, da normalerweise die Fehlerstelle ohne Hochspannungsimpuls nicht wieder von allein durchschlägt.

Vorteilhaft ist, wenn die Netzspannung aus dem Hochleistungsteil des Niederspannungsnetzes bezogen wird. Der Anschluss erfolgt dabei also nicht an einer mit 16 A abgesicherten Haushaltssteckdose, sondern an Leitungen des Niederspannungsnetzes, die zu dessen Hochleistungsteil gehören, das aufgrund seines niedrigen Innenwiderstandes extrem große Ströme liefern kann. In dem erzeugten Lichtbogen können daher erforderliche Stromspitzen von mehreren 1000 A fließen, womit gewährleistet wird, dass der Lichtbogen für die Reflexionsmethode ausreichend ruhig und störungsarm brennt und für die akustische Methode ausreichende Impulsenergie liefern kann.

Erfindungsgemäß ist eine den Hochspannungsimpuls zum Netz hin sperrende Einrichtung vorgesehen. Damit wird verhindert, dass der Hochspannungsimpuls in das niederohmige Netz läuft und durch dieses abgeschwächt wird.

Die Sperreinrichtung kann beispielsweise als Drossel ausgebildet sein, die so ausgebildet ist, dass sie den niederfrequenten Wechselstrom des Netzes passieren lässt, den schnellen und steilen Hochspannungsimpuls jedoch sperrt.

Erfindungsgemäß ist der Schalter zwischen dem Defektleiter und dem Phasenleiter angeordnet. Wenn er öffnet, sorgt er für eine Sperrung des Hochspannungsimpulses, so dass dieser nicht rückwärts ins Netz gelangen kann. Der Schalter kann daher alternativ zur Drossel als Sperreinrichtung verwendet werden. Der Schalter kann natürlich auch für eine Reihe weiterer Zwecke verwendet werden, er kann z.B. auch zum Ein-/ und Ausschalten des Netzes oder auch als Sicherung verwendet werden.

Vorteilhaft ist, wenn der Schalter derart gesteuert ist, dass er bei der mit dem Hochspannungsimpuls überlagerten Halbwelle der Netzspannung während des Anfangsteiles bis einschließlich des Hochspannungsimpulses öffnet und nur den nachfolgenden Teil dieser Halbwelle durchlässt. Damit wird erreicht, dass der Hochspannungsimpuls nicht zurücklaufen kann, der unmittelbar anschließend schließende Schalter lässt aber den anschließenden Teil der Halbwelle des Phasenstromes durch. Dabei muss dafür Sorge getragen werden, dass das Schließen des Schalters im Zeitbereich des Endes des Hochspannungsimpulses erfolgt, also rechtzeitig, um anschließend an den von dem Hochspannungsimpuls erzeugten Durchschlag den Netzstrom fließen zu lassen, bevor das durch den Durchschlag erzeugte Plasma erkaltet.

Vorteilhaft ist, wenn der Schalter als Thyristor ausgebildet ist. Thyristoren sind als Schalter für Niederspannungsnetze sehr gut geeignet. Sie lassen sich jederzeit in einer Halbwelle der Phasenspannung zünden und eignen sich daher für die vorliegenden Zwecke.

Dabei kann mit dem Thyristor eine Diode in Reihe geschaltet sein. Damit kann die Sperrspannung der aus Thyristor und Diode bestehenden Reihenschaltung erhöht werden. Die Diode kann auch mit ausreichender Spannungsfestigkeit zum Sperren des Hochspannungsimpulses dienen.

Gemäß einer vorteilhaften Ausgestaltung wird der Thyristor bereits während des Hochspannungsimpulses gezündet. An ihm liegt dann die hohe Spannung des Hochspannungsimpulses auf der Seite des Defektleiters an, während auf der Netzseite die niedrige Netzspannung anliegt. Der Thyristor wird also in falscher Richtung mit Spannung beaufschlagt und kann so lange nicht zünden, bis die Spannung des Hochspannungsimpulses soweit abgefallen ist, dass sie geringer ist als die Netzspannung. Der Thyristor zündet dann erst durch, also genau im richtigen Moment. Das Ganze geschieht von allein, ohne aufwendige, zeitlich hoch auflösende Steuerung. Mit der Triggerschaltung kann der Thyristor fast gleichzeitig mit dem Start des Hochspannungsimpulses, jedoch kurz nach diesem getriggert werden.

In der Zeichnung ist die Erfindung beispielsweise und schematisch dargestellt. Es zeigen:
- Fig. 1: das Schaltbild einer erfindungsgemäßen Vorrichtung,
- Fig. 2: eine Darstellung des zeitlichen Spannungsverlaufes bei einem erfindungsgemäßen Testvorgang,
- Fig. 3: eine Darstellung gemäß Fig. 2 in einer Ausführungsvariante,
- Fig. 4: eine Darstellung gemäß Fig. 1 in einer Ausführungsvariante,
- Fig. 5: eine Darstellung gemäß Fig. 2 in einer weiteren Ausführungsvariante, und
- Fig. 6: eine Ausschnittsvergrößerung aus Fig. 5.

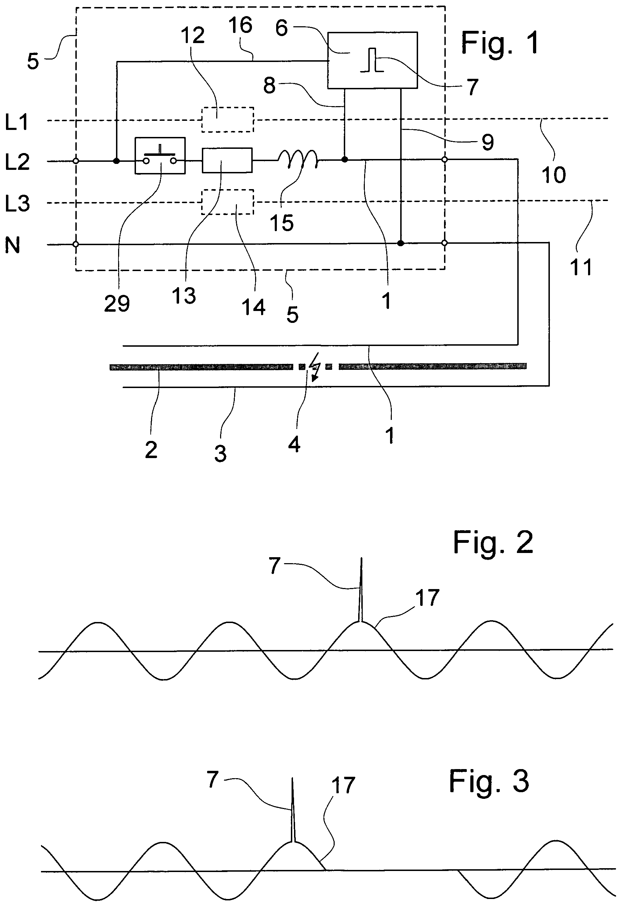

In dem stark schematisierten Schaltbild der Fig. 1 ist ein Defektleiter 1 eines mit der üblichen Wechselspannung von 230 V betriebenen Niederspannungsnetzes dargestellt, der mit einer Isolierung 2 gegen einen Parallelleiter 3 isoliert ist, der ein paralleler Phasenleiter oder auch ein Schutzleiter sein kann. Die Isolierung hat an einer mit Strichelung dargestellten Defektstelle 4 einen Fehler, an dem es zu einem Durchschlag (Blitzsymbol) kommen kann. Die Defektstelle 4 liegt irgendwo unzugänglich, z.B. in der Erde vergraben. Zur Reparatur muss die Defektstelle 4 gefunden werden.

In sogenannten Vorortungsverfahren, die z.B. mittels Impulsreflektionsmethoden arbeiten, kann die Stelle auf der Länge des Leiters 1 bestimmt werden. Man weiß dann z.B., dass die Stelle 86 m +/- 10 m vom Einspeisepunkt entfernt auf dem Defektleiter 1 liegt. Im Zweifelsfall müsste bei dieser Genauigkeit eine gesamte Straßenkreuzung aufgegraben werden.

Es wird daher ein Nachortungsverfahren angewendet. Hätte die Defektstelle einen Fehler gegen Erde, so könnte die Schrittspannungsmethode verwendet werden. Im vorliegenden Fall besteht der Isolationsfehler aber zwischen zwei Leitern, nämlich zwischen dem Defektleiter 1 und dem Parallelleiter 3. Dafür ist die Schallortungsmethode geeignet.

Für beide Methoden (Vorortung und Nachortung) muss an der Defektstelle 4 ein Durchbruch mit Zündung eines Lichtbogens erzeugt werden.

Mit der dargestellten Vorrichtung 5 wird zwischen Defektleiter 1 und Parallelleiter 3 ein elektrischer Impuls angelegt, der an der Defektstelle 4 einen elektrischen Durchschlag erzeugt. Dieser muss für die Reflexionsmethode von ausreichender zeitlicher Länge sein. Für die akustische Methode muss der Impuls so stark sein, dass das erzeugte Geräusch in zum Nachweis ausreichender Entfernung noch hörbar ist, z.B. an der Straßenoberfläche. Durch Schallortung lässt sich dann die Lage der Defektstelle sehr eng lokalisieren.

An der Defektstelle 4 liegt in den meisten Fällen eine nur zeitweilige Schwächung der Isolierung 2 vor. Es muss also zunächst ein Durchschlag provoziert werden, wozu Hochspannung zwischen üblicherweise 3 und 4 kV benötigt wird. Höhere Spannungen wären zur Erzeugung eines Durchschlages günstiger, sind aber bei einem Niederspannungsnetz zum Schutz der Installation und etwaig angeschlossener Verbraucher nicht zulässig. Das bei der Verwendung höherer Spannungen erforderliche Abkoppeln der empfindlichen Verbraucher will man einsparen.

Die erfindungsgemäße Vorrichtung 5 weist zu diesem Zweck einen Generator 6 auf, der einen Hochspannungsimpuls 7 erzeugen kann. Mit den Leitungen 8 und 9 wird der Hochspannungsimpuls 7 zwischen Defektleiter 1 und Parallelleiter 3 angelegt.

Die Spannung des Hochspannungsimpulses ist von derartiger Höhe gewählt, dass die Isolierung 2 an der vorgeschwächten Stelle durchschlagen wird. Der Impuls ist so lang, dass ein Plasma gezündet werden kann, aber derart kurz, also von derart geringer Energie, dass die zulässigen Grenzwerte nicht überschritten werden, bis zu denen Impulsenergien von Störimpulsen von angeschlossenen Verbrauchern noch vertragen werden, wenn diese Verbraucher entsprechend den Störfestigkeitsempfehlungen des Netzbetreibers ausgebildet sind.

Entsprechend ist die Leistung des Generators 6 sehr klein. Er kann z.B. mit einer Taschenlampenbatterie versorgt werden. Bei ausreichender Höhe der Spannung reichen auch sehr geringe Energien, um den gewünschten Durchschlag zu erzeugen.

Allerdings ist dann der Durchschlag so schwach, dass man ihn keinesfalls hören oder akustisch orten kann. Dazu wird wesentlich mehr Energie benötigt. Außerdem wäre er auch für die Reflexionsmethode zu kurz und zu schwach, um die Reflexion eines Ortungsimpulses zu ermöglichen.

Daher wird die Durchschlagstelle an der Defektstelle 4 mit der Spannung eines angeschlossenen Niederspannungsnetzes, also z.B. 230 V beaufschlagt. Dazu ist im Ausführungsbeispiel der Parallelleiter 3 an den Nullleiter N eines Niederspannungsnetzes angeschlossen. Dies kann auch der Schutzleiter PE oder der kombinierte Nullleiter/Schutzleiter PEN sein. Der Defektleiter 1 ist an den Phasenleiter L2 des Niederspannungsnetzes angeschlossen. Gestrichelt sind, nur zur Verdeutlichung des üblichen Netzes, zwei weitere Leiter 10 und 11 dargestellt, die an die Phasenleiter L1 und L3 des Netzes angeschlossen sind. Zur Vervollständigung sind auch Netzsicherungen 12, 13 und 14 dargestellt, von denen die Sicherung 13 den Defektleiter 1 mit dem Phasenleiter L2 verbindet. Dieser ist nur als Beispiel gewählt. Es kann auch einer der beiden anderen Phasenleiter L1 oder L3 verwendet werden.

Im Ausführungsbeispiel der Fig. 1 ist zwischen dem Einspeisungspunkt, an dem mit dem Leiter 8 der Hochspannungsimpuls 7 auf den Defektleiter 1 gegeben wird, und der Netzsicherung 13, also dem Anschluss an die Phase L2 des Netzes, eine Drossel 15 angeordnet.

Das Niederspannungsnetz wird über einen Schalter 29 zu- und abgeschaltet. Damit kann die Länge des an die Defektstelle 4 anzulegenden Niederspannungsimpulses geeignet gewählt werden.

Wenn der Hochspannungsimpuls 7 gegeben wird, wird an der Defektstelle 4 ein Durchschlag erzeugt, der mit einem Plasmapfad eine gut leitende Verbindung zwischen den Leitern 1 und 3 erzeugt. Durch diese niederohmige Verbindung kann die anliegende Netzspannung, also die Spannung zwischen L2 und N, in Form eines Niederspannungsimpulses von großer Länge einen hohen Strom erzeugen, aus dem sich ein Durchschlag sehr hoher Leistung ergibt, den man gut und in großem Abstand hören kann. Die Länge des Impulses ist auch hervorragend für die Reflexionsmethode geeignet. Der Anteil des Niederspannungsimpulses, der zeitlich vor dem Hochspannungsimpuls 7 liegt, kann weggelassen werden, da vor der Zündung durch den Hochspannungsimpuls 7 noch kein Strom fließen kann.

Bei den Phasenleitern L1, L2, L3 handelt es sich bevorzugt um Leiter aus dem Hochleistungsteil des Niederspannungsnetzes. Das ist der Teil des Niederspannungsnetzes, der zur Versorgung größerer Teile des Niederspannungsnetzes dient, z.B. zur Versorgung mehrerer Straßenzüge mit vielen angeschlossenen Haushalten. Der Hochleistungsteil des Niederspannungsnetzes ist sehr niederohmig, also mit großen Leitungsquerschnitten versehen, über sehr starke und träge Sicherungen angeschlossen und von sehr starken Transformatoren versorgt. Er kann somit in dem hier interessierenden sehr kurzen Zeitbereich, über den ein Lichtbogen brennen muss, die erforderlichen kurzzeitigen Stromspitzen von einigen 1000 A liefern.

Die Drossel 15 sorgt dabei dafür, dass der Hochspannungsimpuls 7 nur vorwärts zur Defektstelle 4 läuft, aber nicht rückwärts in den Phasenleiter L2 des Netzes. Damit wird verhindert, dass der Hochspannungsimpuls durch den niederohmigen differentiellen Innenwiderstand des Netzes abgeschwächt wird.

Fig. 2 zeigt die am Defektleiter 1 liegende Wechselspannung in ihrem zeitlichen Verlauf. Es handelt sich um den Niederspannungsimpuls, in Form einer Wechselspannung, wobei der Impuls so lang ist, dass Anfang und Ende außerhalb der Fig. 2 liegen. An einer Stelle ist der Hochspannungsimpuls 7 zu erkennen. Man sieht, dass dieser vorteilhaft auf dem Maximum der Halbwelle 17 liegt, zu der er zeitlich gehört. Dadurch wird erreicht, dass sich der Hochspannungsimpuls und die Netzspannung verstärken. Diese Lage des Impulses 7 relativ zur Halbwelle 17 wird durch eine in Fig. 1 dargestellte Triggerleitung 16 erreicht, die den Generator 6 mit der Spannung L2 des Netzes synchronisiert.

In Fig. 2 ist dargestellt, dass die Wechselspannung des Netzes sehr lange an dem Defektleiter 1 anliegt und an einer Stelle der Hochspannungsimpuls 7 überlagert wird.

Vorteilhaft wird der so gebildete elektrische Impuls 7, 17 von Zeit zu Zeit wiederholt, also beispielsweise nach 10 Sekunden, beziehungsweise 1000 Halbwellen.

Bei ununterbrochenem Dauerbetrieb der Wechselspannung würde der einmal gezündete Durchschlag an der Defektstelle 4 dauernd mit hoher Leistung brennen und zu Zerstörungen führen. Daher ist der angelegte Niederspannungsimpuls zeitlich begrenzt.

Vorteilhaft ist dazu der Schalter 29 gemäß Fig. 1 vorgesehen, der nach dem Hochspannungsimpuls 7 die angelegte Wechselspannung unterbricht, so wie dies die Fig. 3 zeigt. Nach dem Ende der Halbwelle 17, in der der Impuls 7 liegt, nachdem also anschließend an den Hochspannungsimpuls 7 Zeit blieb, um mit entsprechender Energie einen ausreichenden Knall zu erzeugen, oder um die Ankunft des zu reflektierenden Ortungsimpulses abzuwarten, wird die Wechselspannung unterbrochen. Sie beginnt später wieder, wie dies die Fig. 3 zeigt, wobei jedoch ohne Hochspannungsimpuls der Durchschlag an der Defektstelle 4 nicht erneut zündet. Auf diese Weise kann ein weitgehend ungestörter Betrieb des Netzes mit kontinuierlicher Wechselspannung gewährleistet werden, der nur von vereinzelten elektrischen Impulsen der in Fig. 3 dargestellten Art unterbrochen ist.

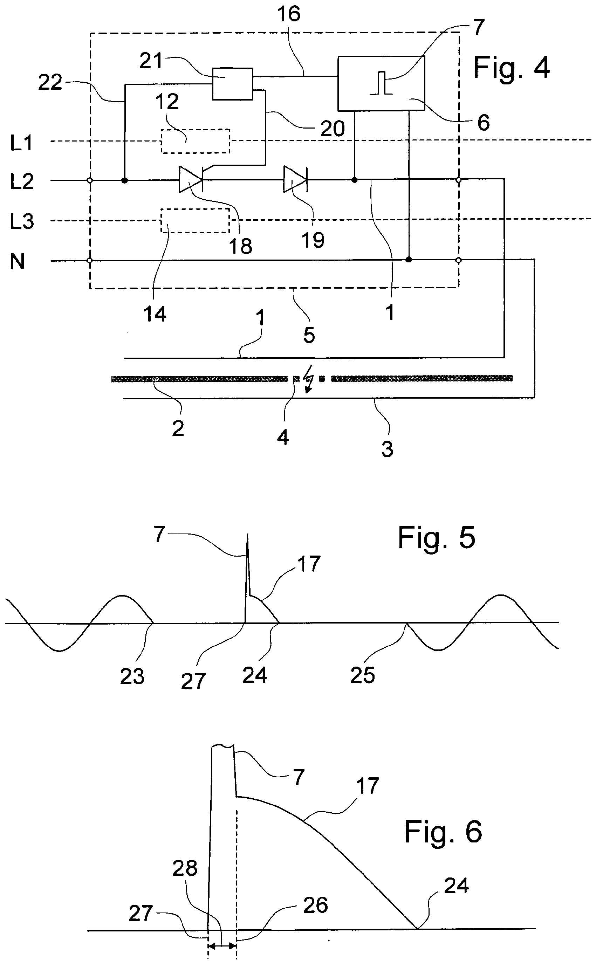

Der erwähnte Schalter zum Unterbrechen des Stromes auf dem Defektleiter 1 kann z.B. anstelle der Sicherung 13 vorgesehen sein, deren Sicherungsfunktion er auch übernehmen kann. Eine solche Lösung zeigt die Fig. 4.

Fig. 4 zeigt ein elektrisches Schaltbild, das dem der Fig. 1 weitgehend entspricht. Es sind, soweit möglich, dieselben Bezugszeichen verwendet.

Anstelle der Sicherung 13 der Fig. 1 ist zwischen Defektleiter 1 und dem Phasenleiter L2 des Netzes eine Reihenschaltung eines Thyristors 18 und einer Diode 19 vorgesehen. Das Gate des Thyristors 18 wird über eine Leitung 20 von einer Triggerschaltung 21 gesteuert, die auch die Triggerleitung 16 zum Generator 6 versorgt und ihrerseits über eine Leitung 22 zur Synchronisierung an den Phasenleiter L2 des Netzes angeschlossen ist. Die Triggerschaltung 21 steuert die Zündung des Thyristors 18 und auch die Auslösung des Hochspannungsimpulses 7.

Die Diode 19 ersetzt die Drossel 15 der Fig. 1, da sie ein Durchlaufen des Hochspannungsimpulses 7 nach rückwärts in das Netz verhindert. Die Diode 19 schützt außerdem mit ihrer hohen Durchschlagsfestigkeit den Thyristor 18 gegen die hohe Spannung.

Das Schaltbild der Fig. 4 ist sehr vereinfacht dargestellt. Es zeigt nur einen Thyristorzweig mit dem Thyristor 18, durch den Strom nur in eine Richtung fließen kann. Es könnte also der Defektleiter 1 nur im Halbwellenbetrieb versorgt werden. Zur Aufrechterhaltung des normalen Vollwellenbetriebs, wie er z.B. in Fig. 2 dargestellt ist, sind zwei antiparallele Thyristorzweige notwendig. Zu dem Thyristor 18 in der Fig. 4 wäre also noch ein umgekehrt gepolter zweiter, in Fig. 4 nicht dargestellter, Thyristor erforderlich, und auch eine zweite zugehörige Diode. Die Thyristoren würden dann in bekannter Weise von der Triggerschaltung 21 so anzusteuern sein, dass immer abwechselnd der eine Zweig und der andere Zweig öffnet, um die positiven und negativen Halbwellen des Netzstromes durchzulassen.

Mit einer solchen Schaltung lässt sich ein Stromverlauf erzeugen, wie er in Fig. 5 dargestellt ist. Zunächst fließt der kontinuierliche Wechselstrom bis zum Zeitpunkt 23. Dann beginnt der elektrische Impuls bei 27 mit Beginn des Hochspannungsimpulses 7 und endet bei 24 mit dem Ende der zugehörigen Halbwelle 17 des Niederspannungsimpulses. Sodann beginnt die Wechselspannung nach einer Lücke erneut bei 25 und läuft dann kontinuierlich weiter. Vor dem Hochspannungsimpuls 7 und nach dem Niederspannungsimpuls wird also der Stromverlauf kurz unterbrochen. In dem Unterbrechungszeitraum zwischen den Zeitpunkten 24 und 25 kann der Stromfluss an der Durchschlagstelle erlöschen. In der Lücke zwischen den Zeitpunkten 23 und 27 ist der Thyristor 18 gesperrt. Der Hochspannungsimpuls 7 kann also nicht rückwärts zum Netz laufen und dort abgeschwächt werden.

Fig. 6 zeigt eine Ausschnittsvergrößerung, in der die den Niederspannungsimpuls bildende Halbwelle 17 mit dem überlagerten Hochspannungsimpuls 7 dargestellt ist. Mit dem Pfeil 28 ist der Zeitraum zwischen dem Start des Hochspannungsimpulses 7 bei 27 und dessen Ende bei 26 dargestellt. Zu dieser Zeit ist die Spannung des Hochspannungsimpulses 7 höher als die Netzspannung. Der Thyristor 18, der zu diesem Zeitpunkt leitend werden soll, um den zweiten Teil der Halbwelle 17 durchzulassen, würde dann eine höhere Spannung an seinem Ausgang als an seinem zum Phasenleiter L2 des Netzes hin liegenden Eingang aufweisen und könnte, da falsch gepolt, nicht leitend werden. Er kann also in diesem durch den Pfeil 28 bezeichneten Zeitraum ohne weiteres über die Leitung 20 einen Zündimpuls auf das Gate erhalten, ohne zünden zu können. Die Zündung würde dann automatisch später und zwar zu dem Zeitpunkt erfolgen, wenn die Spannung an seinem Ausgang niedriger wird als an seinem Eingang, wenn also die Spannung des Hochspannungsimpulses 7 unter die der Halbwelle 17 fällt. Zum Zeitpunkt 26 würde also automatisch die Zündung des Thyristors 18 erfolgen. Dann muss aber der Zündimpuls am Gate des Thyristors noch anliegen. Der Zündimpuls muss also zwischen den Zeitpunkten 27 und 26 anfangen und bei 26 noch bestehen. Somit kann die Triggerschaltung 21 ohne weiteres den Thyristor 18 und den Generator 6 gleichzeitig triggern, was die Schaltung wesentlich vereinfacht.

Bei dem Hochspannungsimpuls 7 ist zu beachten, dass er in seinem Flächeninhalt, also seiner Energie, kleiner ist als die zulässige Energie von Überspannungsimpulsen, mit der an das Netz angeschlossene Verbraucher beaufschlagt werden dürfen, ohne Schaden zu nehmen. Normgerechte Entstörschaltungen sorgen dafür, dass solche Impulse in der Eingangsschaltung der Geräte abgebaut werden, ohne Störungen zu ergeben. Wenn der erfindungsgemäß verwendete Hochspannungsimpuls 7 kleinere Leistung hat als solche zulässigen Überspannungsimpulse, dann kann die erfindungsgemäße Vorrichtung 5 bei laufendem Netzbetrieb eingesetzt werden. Es können also Fehler im Netz gesucht werden, wenn das Netz im Betrieb ist und Verbraucher versorgt.

Die beschriebene Methode ist besonders für die Anforderungen bei Niederspannungsnetzen zugeschnitten. Die normale Netzspannung liegt dann unter ca. 1000V Wechselspannung oder 1500 V Gleichspannung. Anzuschließende Verbraucher sind ausgelegt, kurze Überspannungsimpulse zu vertragen. Für diese gilt im deutschen Niederspannungsnetz die Norm DIN EN 61010-1. Danach sind Überspannungsimpulse zulässig mit der Impulsform 1,2/50µs (Anstiegszeit 1,2 Mikrosekunden, Abfallzeit 50 Mikrosekunden bis auf halbe Höhe) bei Scheitelspannungen von 2,5 kV bis 6 kV je nach Messkategorie. Auch der zulässige Kurzschlussstrom ist hier definiert. Wird der Hochspannungsimpuls 7 innerhalb dieser Grenzen erzeugt, so lassen sich damit die meisten zu Störungen führenden Isolationsfehler zünden. Verbraucher können gefahrlos angeschaltet bleiben.

Der mit einer erfindungsgemäßen Vorrichtung 5 an einer Defektstelle 4 erzeugte Impuls hoher Länge und Energie kann, wie bereits erwähnt, zur Reflexionsortung oder zur akustischen Ortung verwendet werden. Zur Ortung sind jedoch auch andere, z.B. magnetische Methoden verwendbar.

## Patentansprüche

1. Verfahren zur Fehlerortung mittels Erzeugung eines elektrischen Durchschlages an einer Defektstelle (4) eines Defektleiters (1), bei dem der Defektleiter (1) mittels eines Schalters (18) gesteuert mit einem Niederspannungsnetz verbunden wird, durch Anlegen eines elektrischen Impulses (7, 17), der aus einem den Durchschlag zündenden Impuls (7) höherer Spannung und einem den Durchschlag verlängernden Impuls (17) niedrigerer Spannung besteht, wobei der Impuls höherer Spannung mittels eines an den Defektleiter (1) angeschlossenen Generators (6) als Hochspannungsimpuls (7) mit einer zur Zündung ausreichenden Spannungshöhe und Dauer und einer Energie erzeugt wird, die geringer ist als die eines Überspannungsimpulses, der für an das öffentliche Niederspannungsnetz anschließbare Verbraucher zulässig ist, und dass der Impuls niedrigerer Spannung als Niederspannungsimpuls (17) in Form eines Abschnittes der Wechselspannung des Niederspannungsnetzes (L1, L2, L3) erzeugt wird, **dadurch gekennzeichnet, dass** der Schalter (18) derart gesteuert ist, dass er zur Sperrung des Hochspannungsimpulses in Richtung des Niederspannungsnetzes (L1, L2, L3) während des Hochspannungsimpulses (7) öffnet, also nicht leitend ist.

2. Verfahren nach Anspruch 1, **dadurch gekennzeichnet, dass** zur akustischen Fehlernachortung die Umgebung der Defektstelle (4) akustisch überwacht wird.

3. Verfahren nach Anspruch 2, **dadurch gekennzeichnet, dass** der Hochspannungsimpuls (7) am Scheitelpunkt einer in ihrer Polarität mit der des Hochspannungsimpulses (7) übereinstimmenden Halbwelle (17) des Niederspannungsimpulses begonnen wird.

4. Verfahren nach einem der vorhergehenden Ansprüche, **dadurch gekennzeichnet, dass** der Niederspannungsimpuls (17) in einem zur Ortung ausreichenden zeitlichen Abstand nach dem Hochspannungsimpuls (7) beendet wird.

5. Verfahren nach einem der vorhergehenden Ansprüche, **dadurch gekennzeichnet, dass** der Niederspannungsimpuls (17) durch Anschluss an den Hochleistungsteil des Niederspannungsnetzes (L1, L2, L3) erzeugt wird.

6. Vorrichtung (5) zur Fehlerortung mittels Erzeugung eines elektrischen Durchschlages an einer Defektstelle (4) eines Defektleiters (1) durch Anlegen eines elektrischen Impulses (7, 17), der aus einem den Durchschlag zündenden Impuls (7) höherer Spannung und einem den Durchschlag verlängernden Impuls (17) niedrigerer Spannung besteht, wobei die Vorrichtung (5) einen Schalter (29, 18) zum Verbinden des Defektleiters (1) mit einem Phasenleiter (L2) eines eine Wechselspannung bereitstellenden Netzes und einen an den Defektleiter (1) angeschlossenen Generator (6) aufweist, der zur Erzeugung eines Hochspannungsimpulses (7) ausgebildet ist, welcher eine zur Zündung des Durchschlags ausreichende Spannungshöhe und Dauer und eine Energie aufweist, die geringer ist als die eines Überspannungsimpulses, der für an ein Niederspannungsnetz anschließbare Verbraucher zulässig ist, **dadurch gekennzeichnet, dass** der Schalter (29, 18) eine den Hochspannungsimpuls (7) in Richtung zum Phasenleiter (L2) sperrende Sperreinrichtung ausbildet, über die der Defektleiter (1) mit dem Phasenleiter (L2) verbunden ist, und wobei der Schalter (29, 18) derart gesteuert ist, dass er zur Sperrung des Hochspannungsimpulses in Richtung des die Wechselspannung bereitstellenden Netzes während des Hochspannungsimpulses (7) öffnet, also nicht leitend ist.

7. Vorrichtung nach Anspruch 6, **dadurch gekennzeichnet, dass** eine mit dem angeschlossenen Phasenleiter (L2) synchronisierte Triggerschaltung (21) vorgesehen ist, die den Hochspannungsimpuls (7) am Scheitelpunkt einer in ihrer Polarität mit der des Hochspannungsimpulses (7) übereinstimmenden Halbwelle (17) der Wechselspannung auslöst.

8. Vorrichtung nach einem der Ansprüche 6 oder 7, **dadurch gekennzeichnet, dass** der Schalter (29, 18) dazu ausgebildet ist, die Wechselspannung in einem zur Ortung ausreichenden zeitlichen Abstand nach dem Hochspannungsimpuls (7) zu beenden.

9. Vorrichtung nach einem der Ansprüche 6 bis 8, **dadurch gekennzeichnet, dass** der Schalter (18) derart gesteuert ist, dass er während des Hochspannungsimpulses (7) und des davor liegenden Teiles der zugehörigen Halbwelle (17) der Wechselspannung nicht leitend ist und im Zeitbereich des Endes (26) des Impulses (7) wieder leitend wird.

10. Vorrichtung nach einem der Ansprüche 6 bis 9, **dadurch gekennzeichnet, dass** der Schalter mit einem Thyristor (18) ausgebildet ist.

11. Vorrichtung nach Anspruch 10, **dadurch gekennzeichnet, dass** mit dem Thyristor (18) eine Diode (19) in Reihe geschaltet ist.

12. Vorrichtung nach einem der Ansprüche 10 oder 11, **dadurch gekennzeichnet, dass** eine Zündeinrichtung (21) einen Zündimpuls für den Thyristor erzeugt, der innerhalb der Zeitspanne (28) des Hochspannungsimpulses (7) beginnt und nach dessen Ende (26) endet.

13. Vorrichtung nach einem der Ansprüche 6 bis 12, **dadurch gekennzeichnet, dass** der Anschluss an das Niederspannungsnetz als Anschluss an den Hochleistungsteil des Niederspannungsnetzes (L1, L2, L3) ausgebildet ist.

## Claims

1. A method for locating a fault by producing an electrical breakdown at a defect location (4) of a defect conductor (1), wherein, by being controlled by means of a switch (18), the defect conductor (1) is being connected to a low voltage system, by applying an electrical pulse (7, 17) consisting of a higher voltage pulse (7) firing the breakdown and a lower voltage pulse (17) prolonging the breakdown, wherein the higher voltage pulse is generated by means of a generator (6) that is connected to the defect conductor (1) as a high voltage pulse (7) having a voltage level and duration sufficient for firing and having an energy which is lower than that of an overvoltage pulse that is allowed for consumers that can be connected to the public low voltage system, and that the lower voltage pulse is generated as a low voltage pulse (17) in the form of a portion of the alternating current voltage of the low voltage system (L1, L2, L3),
**characterised in that**
- the switch (18) is controlled in such a manner that, in order to disable the high voltage pulse, it opens towards the low voltage system (L1, L2, L3) during the high voltage pulse (7), i.e. is non-conductive.

2. The method in accordance with Claim 1, **characterised in that** the environment of the defect location (4) is acoustically monitored in order to subsequently locate the fault.

3. The method in accordance with Claim 2, **characterised in that** the high voltage pulse (7) is started at the peak of a half wave (17) of the low voltage pulse, said half wave (17) corresponding to that of the high voltage pulse (7) in its polarity.

4. The method in accordance with any one of the preceding claims, **characterised in that** the low voltage pulse (17) is terminated at a time period subsequent to the high voltage pulse (7) that is sufficient to locate the fault.

5. The method in accordance with any one of the preceding claims, **characterised in that** the low voltage pulse (17) is generated by being connected to the high performance section of the low voltage system (L1, L2, L3).

6. A device (5) for locating a fault by generating an electrical breakdown at a defect location (4) of a defect conductor (1) by applying an electrical pulse (7, 17) consisting of a higher voltage pulse (7) firing the breakdown and a lower voltage pulse (17) prolonging the breakdown, wherein the device (5) has a switch (29, 18) to connect the defect conductor (1) to a phase conductor (L2) of a system providing an alternating current voltage and a generator (6) connected to the defect conductor (1), said generator (6) being configured to generate a high voltage pulse (7) which has a voltage level and duration sufficient for firing the breakdown and an energy which is lower than that of an overvoltage pulse that is allowed for consumers that can be connected to a low voltage system, **characterised in that** the switch (29, 18) forms a disabling device that disables the high voltage pulse (7) towards the phase conductor (L2), said disabling device serving to connect the defect conductor (1) to the phase conductor (L2), and wherein the switch (29, 18) is controlled in such a manner that, in order to disable the high voltage pulse, it opens towards the system providing the alternating current voltage during the high voltage pulse (7), i.e., is non-conducting.

7. The device in accordance with Claim 6, **characterised in that** a trigger circuit (21) synchronised with the connected phase conductor (L2) is provided, said trigger circuit (21) triggering the high voltage pulse (7) at the peak of a half wave (17) of the alternating current voltage that corresponds to the high voltage pulse (7) in its polarity.

8. The device in accordance with any one of Claims 6 or 7, **characterised in that** the switch (29, 18) is configured to terminate the alternating current voltage at a time period subsequent to the high voltage pulse (7) that is sufficient to locate the fault.

9. The device in accordance with any one of Claims 6 to 8, **characterised in that** the switch (18) is controlled in such a manner that it is non-conductive during the high voltage pulse (7) and the portion of the associated half wave (17) of the alternating current voltage preceding it and becomes conductive again within a period at the end (26) of the pulse.

10. The device in accordance with any one of Claims 6 to 9, **characterised in that** the switch is formed with a thyristor (18).

11. The device in accordance with Claim 10, **characterised in that** a diode (19) is connected in series with the thyristor (18).

12. The device in accordance with any one of Claims 10 or 11, **characterised in that** a firing device (21) generates a firing pulse for the thyristor, said firing pulse starting within the time period (28) of the high voltage pulse (7) and stopping after the end thereof.

13. The device in accordance with any one of Claims 6 to 12, **characterised in that** the connection to the low voltage system is configured as a connection to the high performance section of the low voltage system (L1, L2, L3).

## Revendications

1. Procédé de localisation de défaut à l'aide d'un claquage électrique produit au niveau du défaut (4) d'un conducteur défectueux (1), le conducteur défectueux (1) étant, lors de ce procédé, connecté de façon contrôlée à un réseau basse tension au moyen d'un commutateur (18) et une impulsion électrique (7, 17) composée d'une impulsion (7) de tension supérieure qui provoque le claquage et d'une impulsion (17) de tension inférieure qui prolonge le claquage étant appliquée, l'impulsion de tension supérieure étant, au moyen d'un générateur (6) connecté au conducteur défectueux (1), produite sous forme d'impulsion haute tension (7) avec une tension et une durée suffisantes pour le déclenchement et avec une énergie inférieure à celle d'une impulsion de surtension admissible pour un consommateur pouvant être branché sur le réseau public basse tension, et l'impulsion de tension inférieure étant générée comme impulsion basse tension (17) sous forme d'un segment de la tension alternative du réseau basse tension (L1, L2, L3), **caractérisé en ce que** le commutateur (18) est commandé de façon s'ouvrir pendant la durée de l'impulsion haute tension (7) pour en empêcher la conduction vers le réseau basse tension (L1, L2, L3), c'est-à-dire de façon à n'être pas conducteur.

2. Procédé selon la revendication 1, **caractérisé en ce que** le voisinage du défaut (4) est placé sous surveillance acoustique pour une relocalisation acoustique.

3. Procédé selon la revendication 2, **caractérisé en ce que** l'impulsion haute tension (7) commence au sommet d'une demi-onde (17) de l'impulsion basse tension dont la polarité correspond à celle de l'impulsion haute tension (7).

4. Procédé selon l'une des revendications précédentes, **caractérisé en ce que** l'impulsion basse tension (17) cesse un certain temps après l'impulsion haute tension (7), à savoir avec un intervalle de temps suffisant pour la localisation.

5. Procédé selon l'une des revendications précédentes, **caractérisé en ce que** l'impulsion basse tension (17) est produite par connexion sur la section de puissance du réseau basse tension (L1, L2, L3).

6. Dispositif (5) de localisation de défaut à l'aide d'un claquage électrique produit au niveau du défaut (4) d'un conducteur défectueux (1) par application d'une impulsion électrique (7, 17) composée d'une impulsion (7) de tension supérieure qui provoque le claquage et d'une impulsion (17) de tension inférieure qui prolonge le claquage, le dispositif (5) présentant un commutateur (29, 18) pour connecter le conducteur défectueux (1) à un fil de phase (L2) d'un réseau fournissant une tension alternative et un générateur (6) branché sur le conducteur défectueux (1) et conçu pour produire une impulsion haute tension (7) avec une tension et une durée suffisantes pour le déclenchement du claquage et avec une énergie inférieure à celle d'une impulsion de surtension admissible pour des consommateurs pouvant être branchés sur un réseau basse tension, **caractérisé en ce que** le commutateur (29, 18) forme un dispositif de verrouillage qui bloque l'impulsion haute tension (7) en direction du fil de phase (L2) et relie le conducteur défectueux (1) au fil de phase (L2), le commutateur (29, 18) étant commandé de façon s'ouvrir pendant la durée de l'impulsion haute tension (7) pour en empêcher la conduction vers le réseau fournissant la tension alternative, c'est-à-dire de façon à n'être pas conducteur.

7. Dispositif selon la revendication 6, **caractérisé en ce qu'**un circuit de déclenchement (21) synchronisé avec le fil de phase (L2) connecté est prévu qui déclenche l'impulsion haute tension (7) au sommet d'une demi-onde (17) de la tension alternative dont la polarité correspond à celle de l'impulsion haute tension (7).

8. Dispositif selon l'une des revendications 6 ou 7, **caractérisé en ce que** le commutateur (29, 18) est conçu pour stopper l'application de la tension alternative un certain temps après l'impulsion haute tension (7), à savoir avec un intervalle de temps suffisant pour la localisation.

9. Dispositif selon l'une des revendications 6 à 8, **caractérisé en ce que** le commutateur (18) est commandé de façon à n'être pas conducteur pendant la durée de l'impulsion haute tension (7) et la partie de la demi-onde (17) correspondante de la tension alternative qui précède l'impulsion, et à redevenir conducteur dans la plage de temps de la fin (26) de l'impulsions (7).

10. Dispositif selon l'une des revendications 6 à 9, **caractérisé en ce que** le commutateur est réalisé avec un thyristor (18).

11. Dispositif selon la revendication 10, **caractérisé en ce qu'**une diode (19) est branchée en série avec le thyristor (18).

12. Dispositif selon l'une des revendications 10 ou 11, **caractérisé en ce qu'**un dispositif de déclenchement (21) produit une impulsion de déclenchement pour le thyristor qui commence à l'intérieur de l'intervalle de temps (28) de l'impulsion haute tension (7) et finit après la fin de cet intervalle (26).

13. Dispositif selon l'une des revendications 6 à 12, **caractérisé en ce que** la connexion sur le réseau basse tension est réalisée par connexion sur la section de puissance du réseau basse tension (L1, L2, L3).
